# EUROPEAN PATENT APPLICATION

(11) **EP 0 717 318 A1**
(43) Date of publication of application: **19.06.1996**
(21) Application number: 95308214.6
(22) Date of filing: 16.11.1995
(51) Int. Cl.: G03F 7/004

(54) **Method of adjusting thixotropy of a photoimageable composition**

(30) Priority: 12.12.1994 US 353762
(71) Applicant: MORTON INTERNATIONAL, INC., Chicago, Illinois 60606 (US)
(72) Inventor: Lien, Shawn, Cypress, California 90630 (US); Tara, Vinai Ming, Anaheim, California 92804 (US)
(74) Representative: Bankes, Stephen Charles Digby

(57) **Abstract**

A method of adjusting thixotropy is provided for a composition comprising
(a) between 10 and 35 wt.% of a polymerizable acrylic monomer,
(b) between 3 and 15 wt.% of a photosensitive, free radical-generating initiator chemical system which in the presence of actinic radiation initiates polymerization of acrylic moieties,
(c) between 5 and 35 wt.% epoxy-acrylate oligomer,
(d) between 20 and 80 wt.% of an epoxy resin composition having an epoxy equivalent between 200 and 700, which epoxy composition is curable to harden said photoimageable composition subsequent to exposure to actinic radiation,
(e) between 0.1 and 10 wt.% of an acidic curative for said epoxy resin, and
(f) up to 15 wt.%, preferably at least 2 wt.%, of a hydroxyl group-reactive cross-linking agent, the percentages being based on the total levels of (a)-(f),

and which components (a)-(f) are selected to form a homogeneous solution in an organic solvent which dries to a homogeneous composition soluble in alkaline aqueous solution, whereby said photoimageable compositon is developable in aqueous or alkaline aqueous solution, and which composition further contains fumed silica at a level of 1 and 5 wt. % based upon the total of components (a)-(f). The method comprising adding to the composition from 50 to 120 wt.%, based on the total weight of (a)-(f), of a solvent which is an ester formed from acetic acid and a C₆-C₈ alcohol or mixtures of C₆-C₈ alcohols plus any additional miscible organic solvent so as to provide a total solvent level of 60 to 120 wt% relative to (a)-(f).

## Description

The present invention is directed to a method of adjusting thixotropy of a photoimageable composition, particularly a photoimageable composition which is hardenable to form a solder mask on the printed circuit board.

### Background of the Invention

U.S. Patent No. 5,229,252, the teachings of which are incorporated herein by reference, describes a solder mask-forming photoimageable composition comprising
(a) between about 15 and about 35 wt. percent of a polymerizable acrylic monomer,
(b) between about 3 and about 15 wt. percent of a photosensitive, free radical-generating initiator chemical system which in the presence of actinic radiation initiates polymerization of acrylic moieties,
(c) between about 5 and about 35 wt. percent epoxy-acrylate oligomer,
(d) between about 20 and about 80 wt. percent of an epoxy resin composition having an epoxy equivalent between 200 and 700, which epoxy composition is curable to harden said photoimageable composition subsequent to exposure to actinic radiation,
(e) between about 0.1 and about 10 wt. percent of an acidic curative for said epoxy resin, and
(f) up to about 15 wt. percent, preferably at least about 2 wt. percent, of a hydroxyl group-reactive cross-linking agent, the percentages being based on the total levels of (a)-(f).

The components (a)-(f) are selected so that said components form a homogeneous solution in an organic solvent which dries to a homogeneous composition which is soluble in alkaline aqueous solution, whereby said photoimageable composition is developable in aqueous or alkaline aqueous solution.

The assignee of U.S. Patent No. 5,229,252, Morton International, Inc., sells such compositions as Epic® series, e.g., Epic® 200, solder mask-forming compositions. For shelf stability, Epic® compositions are provided as two-part systems with components that might tend to prematurely interact being isolated in the two-part system. U.S. Patent no. 5,229,252 furthermore gives examples in which fumed silica (Cabosil® EH5) is added as a filler. Fumed silica, if added, is typically added at between about 1 and about 5 wt.% of components (a)-(f). For viscosity adjustment, whereby the composition may be readily applied as a flowing liquid to a printed circuit board, part A and/or part B typically contains an organic solvent such as ethylene glycol mono butyl ethyl acetate (EBA), propylene glycol mono methyl ether (PM), propylene glycol mono methyl ether acetate (PMA), ethylene glycol monobutyl ether (EB), diethylene glycol mono ethyl ether (DE), and ethyl-3-ethoxy propionate (EEP). Currently EBA is a preferred solvent, providing a high gloss solder mask. The solvent is typically present at between about 20 and about 100 wt%, depending upon the method by which the composition is to be applied, e.g., screen printing, electrostatic spray, roller coating, curtain coating, etc.

In the interest of more rapidly coating printed circuit boards with photoimageable composition, it has been proposed to coat circuit boards held in a vertical position and conveyed before atomizers which spray the photoimageable composition on the boards. (For purposes of this invention, circuit boards held within 25° of vertical will be considered to be held "substantially vertical".) When applying compositions as described above by spraying the composition onto vertically held boards, significant problems were encountered. To pass through useful atomizers, the viscosity has to be sufficiently low, typically requiring organic solvent at levels of between about 60 and about 120 wt% based on total levels of components (a)-(f). Unfortunately, providing a sufficiently low viscosity for efficient atomizing typically provides a viscosity so low that the composition, when applied to the vertically held printed circuit board, sags, i.e., tends to run down the board. Accordingly, a primary object of the present invention was to provide a composition containing components (a)-(f) as described above which could be applied by atomization to a vertically or substantially vertically held board.

One approach attempting to reduce the sag of the composition was to significantly enhance the level of fumed silica. However, levels of fumed silica sufficient to prevent sag when the composition was applied to a vertically held board resulted in a solder mask with significantly less gloss, i.e., a more matte finish.

### Summary of the Invention

A method of adjusting thixotropy is provided for a composition comprising
(a) between about 15 and about 35 wt. percent of a polymerizable acrylic monomer,
(b) between about 3 and about 15 wt. percent of a photosensitive, free radical-generating initiator chemical system which in the presence of actinic radiation initiates polymerization of acrylic moieties,
(c) between about 5 and about 35 wt. percent epoxy-acrylate oligomer,
(d) between about 20 and about 80 wt. percent of an epoxy resin composition having an epoxy equivalent between 200 and 700, which epoxy composition is curable to harden said photoimageable composition subsequent to exposure to actinic radiation,
(e) between about 0.1 and about 10 wt. percent of an acidic curative for said epoxy resin, and
(f) up to about 15 wt. percent, preferably at least about 2 wt. percent, of a hydroxyl group-reactive cross-linking agent, the percentages being based on the total levels of (a)-(f),
and which components (a)-(f) are selected so that the components form a homogeneous solution in an organic solvent which dries to a homogeneous composition which is soluble in alkaline aqueous solution, whereby said photoimageable composition is developable in aqueous or alkaline aqueous solution, and which composition further contains fumed silica at a level of between about 1 and about 5 wt% based upon the total of components (a)-(f), the method comprising adding to the composition between about 50 and about 120 wt% of a solvent based upon the total of components (a)-(f) which is a ester formed from acetic acid and a C₆-C₈ alcohol or mixtures of such C₆-C₈ alcohols plus any such additional miscible organic solvent as is necessary to provide solvent at a level of between about 60 and about 120 wt% based upon the total of components (a)-(f).

By appropriate addition of the ester as solvent, the thixotropy adjusts such that the composition can be atomized and applied as a spray to a board held substantially vertical yet be resistant to sag, once applied.

### Detailed Description of Certain Preferred Embodiments

The photoimageable compositions to which the method of the present invention is directed are those which contain at least the following components: (a) acrylic monomers, (b) photoinitiator(s), (c) epoxy-acrylate oligomers, (d) epoxy resins, and (e) an acidic curative for the epoxy resins. Generally the photoimageable composition also includes (f) a cross-linking agent such as a melamine-formaldehyde resin or a blocked multifunctional isocyanate. These components (a)-(f) are selected to be mutually miscible in an organic solvent or organic solvent mixture so that when they are mixed together in an organic solvent, these components form a clear homogeneous solution. Upon evaporation of the organic solvent, components (a)-(f) are mutually compatible so as to form a homogeneous dried composition. Herein, unless otherwise stated, all percentages are by weight and are calculated relative to the total weight of components (a)-(f). The amounts of fumed silica, solvents, and any additional ingredients, such as fillers, etc. are calculated relative to the sum of the weights of (a)-(f). The homogeneous dried composition of (a)-(f) is soluble in alkaline aqueous solution, whereby the photoimageable composition as a layer on a printed circuit board is developable with alkaline aqueous solution.

The composition includes an acrylic chemical system by which the composition is photopolymerized and an epoxy chemical system which is curable to harden the composition after exposure and development. The two chemical systems, however, are not exclusive of each other and components of the two chemical systems are believed to interact chemically with each other. This is especially true when the composition includes a cross-linking agent (f).

The acrylic system includes the acrylic monomers (a), the epoxy-acrylate oligomer (c) and the photoinitiator (b). The epoxy system includes the epoxy resin (d) and the acidic curative (e) therefor. If a cross-linking agent (f) is used, it is selective to be reactive with free hydroxyl groups of components of both the acrylic and epoxy systems.

The monomers are selected from a variety of esters of acrylic acids, such as methyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, trimethylolpropane triacrylate, pentaerythritol triacrylate, 2,2-di(p-hydroxy-phenyl)propane diacrylate, pentaerythritol tetracrylate, 2,2-di(p-hydroxyphenyl)-propane dimethacrylate, triethylene glycol diacrylate, polyoxyethyl-2-2-di(p-hydroxyphenyl)propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate. The acrylic monomers (a) typically comprise between 10 and about 40 wt. percent of components (a)-(f). Lower levels may be insufficient to insolubilize the portions of the photoimageable composition layer that have been exposed to actinic radiation. Higher levels of acrylic monomers may result in a solder mask which is too soft for many applications.

By epoxy-acrylate oligomer (c) is meant, herein, an oligomer formed from an epoxy backbone which is reacted with acrylic acids so that at least about 90% of the epoxy groups are esterified with the acrylic acids. Acrylic acids, such as those used in the acrylic (ester) monomers described above are suitable for this purpose. In reaction of the acrylic groups with the epoxy groups of the epoxy oligomer, the acid molecules each forms an ester bond with the oligomer background and a hydroxyl group is formed on the vicinal carbon atom. Because substantially all of the epoxy groups are reacted with acrylic acid moieties, the epoxy-acrylate oligomer functions primarily as an acrylate, the acrylate moieties of the oligomer polymerizing along with the acrylic monomers during the photoinitiated reaction which renders exposed portions of the photoimageable composition layer insoluble to aqueous alkaline solution. The substantial hydroxyl functionality provides the basis for cross-linking with the cross-linking agent (f), if such a cross-linking agent (f) is used.

Preferred epoxy-acrylate oligomers are diacrylate (or methacrylate) esters of bisphenol A type resins. These oligomers are developed to combine good UV/EB cure response along with the chemical resistance and durability of the epoxy resins. The epoxy-acrylate oligomers are derived from bisphenol A resins having a functionality of two so they also have a functionality of two.

The synthesis of polyfunctional acrylate resins and other unsaturated esters from the corresponding epoxy derivatives is described in the following U.S. patents: 3,256,226; 3,317,465; 3,345,401; 3,373,221; 3,377,406; 3,432,478; 3,548,030; 3,564,074; 3,634,542 and 3,637,618.

The epoxy-acrylate oligomer generally comprises between about 5 and about 25 wt. percent of the total weight of components (a)-(f), preferably between about 12 and 18 wt. percent. Epoxy-acrylate oligomers used in the photoimageable composition preferably have molecular weights of between about 500-2000.

Also required in conjunction with the polymerizable acrylate substance is a chemical initiator system which generates free radicals in the presence of actinic radiation and thereby causes the polymerization of the acrylic substances. Polymerization of acrylic monomers and acrylic moieties of the epoxy-acrylate oligomers into a three-dimensional structure insolubilizes the photoimageable composition. The choice of the photosensitive, free radical-generating initiator system is not considered to be critical to the practice of the present invention, and a wide variety of such compounds may be successfully utilized in the practice of this invention. Examples of chemical photoinitiator systems include benzophenone, benzoin ether, benzil ketals and acetophenone and its derivatives. Other suitable initiator systems are described, for example, in U.S. Patent Nos. 3,469,982, 4,451,523 and 4,358,477, the teachings of which are incorporated herein by reference. The amount of photoinitiator employed may vary over a wide range, depending upon the polymerizable acrylic substances, the particular photoinitiator system and the desired time of development. Generally, the photoinitiator chemical system comprises between about 3 and about 15 wt. percent of the total weight of components (a)-(f).

The material which imparts the excellent hardness and durability to the film or layer after development and final curing is the epoxy resin or mixture of epoxy resins. The epoxy resin or resins comprise between about 20 and about 80 percent by weight (preferably between about 30 and about 60 wt. percent) of the total weight of components (a)-(f). At high temperatures and/or in the presence of a catalyst, the epoxy groups of the resin molecules open and react with other materials present. Primarily the epoxy resin molecules react with the acidic curative (e); however, to a certain extent, the epoxy molecules react during final curing with the cross-linking agent (f), and perhaps also with the photopolymerized acrylic material and any remaining unpolymerized acrylate monomers or moieties. Preferably the epoxy resin or mixture of resins is solid at about room temperature. The photoimageable composition can be applied as a liquid film to the substrate after dissolving the solid epoxy resin in the solvent-based mixture first.

A wide variety of epoxy resins are suitable for use in accordance with the present invention. Typically, epoxies of the Bisphenol A and Novalac type are used. Other suitable epoxy resins are described, for example, in U.S. Patent No. 4,092,443, the teachings of which are incorporated herein by reference. Cycloaliphatic epoxides, such as those sold under the trade names Cyanacure UVR-6100 and UVR-6110 by Union Carbide, Danbury, CT are also useful. Epoxy resins used in accordance with the invention preferably have epoxide equivalents of between 200 and about 700.

The photoimageable composition according to this invention is intended to be hardened to form a permanent photomask. Hardening is primarily attributed to the curing of the epoxy resin. To promote sufficiently rapid curing of the epoxy resin, the photoimageable composition of the present invention employs an acidic curative. Acidic cure catalysts include not only substances which have free carboxyl groups, but also chemicals such as anhydrides, which may produce free carboxyl groups. In fact, for many applications of the present invention, an anhydride, e.g., an anhydride of a multifunctional carboxylic acid is the preferred curative. Other useful catalysts are those having a blocked carboxylic group, which becomes de-blocked at a threshold temperature. Epoxy cure catalysts are generally used at levels of from about 0.1 to about 10 wt. percent of the total weight of components (a)-(f).

Although photoimageable compositions in accordance with the present invention do not necessarily require an additional cross-linking agent, a cross-linking agent (f) is highly desirable. A cross-linking agent is particularly useful in connecting the acrylate chemical system and the epoxy chemical system in a single interconnected network in the final solder mask layer. Free hydroxyl groups, e.g., on the epoxy resins and the epoxy-acrylate oligomers, generally provide the basis for such cross-linking. The cross-linking agent (f) is typically used at a level of at least about 2 wt. percent, 3-5 wt. percent being preferred.

One type of suitable crosslinking agent is a melamine-formaldehyde resin. A melamine-formaldehyde resin is particularly useful if the epoxy curative is an anhydride. During initial application of the photoimageable composition as a layer, it is believed that the melamine-formaldehyde resin reacts to some extent with the anhydride. This opens the anhydride, providing carboxyl functionality for subsequent epoxy curing. This initial reaction also has a surface drying effect. Melamine-formaldehyde resin acts to cross-link through free hydroxyl groups. Preferred melamine-formaldehyde resins have methylated melamine moieties.

Alternatively, a blocked, multifunctional isocyanate may be used as the cross-linking agent. The blocked isocyanate is selected to de-block generally at the cure temperature of the epoxy resin. An example of a suitable blocked isocyanate is Σ-caprolactam-blocked isophorone. If a blocked isocyanate is the cross-linking agent and an anhydride is the curative, some preheating of the photoimageable composition at a time prior to cure is desirable. Such preheating opens anhydride species, providing the acid functionality needed to promote curing of the epoxy resin.

Components (a)-(f) are selected such that a homogeneous dried composition of these is soluble in alkaline aqueous solution, whereby a layer of the photoimageable composition may be developed in alkaline aqueous solution, e.g., 1% sodium carbonate.

For adjusting the thixotropy, fumed silica, such as that sold as Cabosil® is added to the composition at between about 1 and about 5 wt% relative to components (a)-(f). The fumed silica is unmodified, so as to have surface -OH groups. The surface area of the fumed silica is between about 100 and about 500 m²/g and preferably between about 200 and about 400 m²/g.

A mixture of components (a)-(f) is typically too viscous to be easily applied as a layer; accordingly, it is generally the practice to dilute the components (a)-(f) with an organic solvent. Typically, solvent is used at a level of 20-120 wt. percent relative to components (a)-(f); for spray applications generally between 60 and about 120 wt% relative to components (a)-(f).

Generally, the solvent used for these compositions is moderately to high hydrogen bonding solvent, such as ethylene glycol mono butyl ethyl acetate (EBA), propylene glycol mono methyl ether (PM), propylene glycol mono methyl ether acetate (PMA), ethylene glycol monobutyl ether (EB), diethylene glycol mono ethyl ether (DE), and ethyl-3-ethoxy propionate (EEP).

In accordance with the invention, to the composition, which may contain one of the solvents listed above, is added an ester(s) of acetic acid with a C₆-C₈ alcohol or alcohols. Such esters include ethylhexylacetate and ester mixtures such as those sold as Exxate® 600, 700, 800 and 900 by Exxon., Exxate® 700 being a currently preferred solvent. The C₆-C₈ ester is added at between about 50 and about 120 wt% relative to (a)-(f), typically between about 50 and about 70 wtT relative to (a)-(f) along with any additional solvents, such as the more hydrogen bonding solvents described above so as to provide a total solvent level of between about 60 and about 120 wt% relative to (a)-(f). Although it would be expected that the addition of solvent would lower the viscosity and thixotropy, it is surprisingly found that the viscosity and thixotropy are raised by the addition of these esters. Accordingly, the thixotropy is adjusted by appropriate addition of the C₆-C₈ acetate ester such that the composition does not sag when applied to a vertically or substantially vertically held printed circuit board.

In addition to the components described above which are essential to a photoimageable composition in accordance with the invention, the photoimageable composition may optionally contain additional components which are standard in the art. The photoimageable composition may contain additions. organic or inorganic fillers at levels up to about 35 wt. percent relative to the total weight of components (a)-(f). Some examples of fillers are micro talc, ground polyethylene, clay, and polyvinylidene fluoride. Also, relatively small amounts of flow-control agents, antioxidants, dyes, etc. may be added.

After the photoimageable composition is applied as a layer to a printed circuit board, the layer is dried to remove organic solvent. During this drying, some reaction of components may occur, particularly between an anhydride and a melamine-formaldehyde resin. After drying, the homogeneous dried photoimageable layer is exposed to patterned actinic radiation and then developed in alkaline aqueous developer in a conventional manner. It is preferred at this time to effect a UV cure to tie up any unreacted acrylate; however, this step is optional. Subsequently, the layer is heat cured, e.g., at 150°C for at least one hour. Prior to heat cure, i.e., prior to activation of the epoxy chemical system, the layer of photoimageable compositions remains strippable by common strippers, should there be any need to remove the layer, e.g., for reworking.

The invention will now be described in greater detail by way of specific example.

### EXAMPLE 1

A composition was prepared as follows:

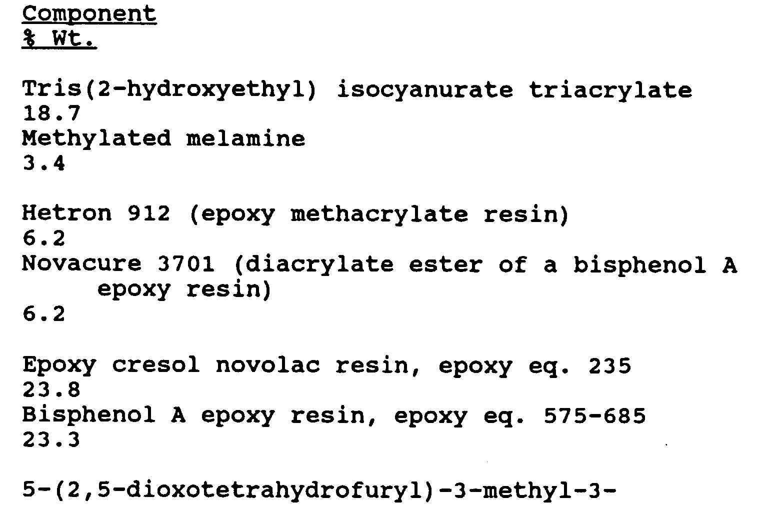

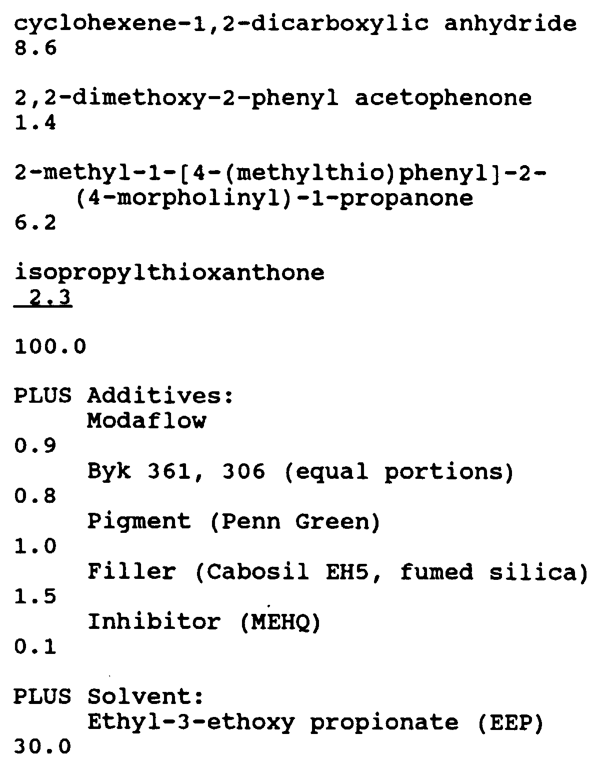

To 2 kilograms of the above formulation was added an additional liter of EEP to facilitate spraying (control composition). To a similar 2 kilogram composition was added 1 liter of Exxate® 700. Vertically held boards were sprayed with the compositions in a Teledyne Halco Unicote® spraying apparatus, wherein a coating to a thickness of 0.1 mm was applied. In the sprayers, the compositions were subjected to shear forces in the range of 20 to 50 psi and estimated shear rates of 10⁴ to 10⁶ sec⁻¹. Sag was measured by ASTM D3730-7S. The coated layers of the control composition had unacceptable sag, whereas the panels coated with the composition containing the Exxate® 700 had acceptable sag.

### EXAMPLE 2

Epic® 200 SP parts A and B were mixed. This formulation contains components described as (a)-(f) above, 5 wt% of Cabosil® EH5 relative to total weight of (a)-(f), and 30 wt% of EBA relative to (a)-(f) as well as conventional additives. To a 2 kilogram sample of this was added an additional liter of EBA (control composition). To a similar 2 kilogram sample of the composition was added 1 liter of Exxate® 700. Vertically held boards were sprayed with the compositions in a Teledyne Halco Unicote® spraying apparatus, wherein a coating to a thickness of 0.1 mm was applied. In the sprayers, the compositions were subjected to shear forces in the range of 20 to 50 psi and estimated shear rates of 10⁴ to 10⁶ sec⁻¹, Sag was measured by ASTM D3730-7S. The coated layers of the control composition had unacceptable sag, whereas the panels coated with the composition containing the Exxate® 700 had acceptable sag.

## Claims

1. A method of adjusting the thixotropy of a composition comprising
(a) from 10 to 40 wt. % of a polymerizable acrylic monomer,
(b) from 3 to 15 wt. % of a photosensitive, free radical-generating initiator chemical system which in the presence of actinic radiation initiates polymerization of acrylic moieties,
(c) from 5 to 35 wt. % epoxy-acrylate oligomer,
(d) from 20 to 80 wt. % of an epoxy resin composition having an epoxy equivalent between 200 and 700, which epoxy composition is curable to harden said photoimageable composition subsequent to exposure to actinic radiation,
(e) from 0.1 to 10 wt. % of an acidic curative for said epoxy resin, and
(f) up to 15 wt. %, preferably at least 2 wt. %, of a hydroxyl group-reactive cross-linking agent, the percentages being based on the total levels of (a)-(f),
said components (a)-(f) being selected so that the components form a homogeneous solution in an organic solvent which dries to a homogeneous composition which is soluble in alkaline aqueous solution, whereby said photoimageable compositon is developable in aqueous or alkaline aqueous solution; said composition further containing fumed silica at a level of 1 to 5 wt. % based upon the total of components (a)-(f), the method comprising adding to the composition from 50 to 120 wt. %, based on total weight of (a)-(f), of a solvent which is an ester formed from acetic acid and a C₆-C₈ alcohol or mixtures of C₆-C₈ alcohols plus any additional miscible organic solvent so as to provide a total solvent level of 60 to 120 wt% relative to (a)-(f).

2. A method according to claim 1 wherein said ester formed from acetic acid and a C₆-C₈ alcohol or mixtures of C₆-C₈ alcohols is added at 50 to 70 wt% relative to (a)-(f).

3. A method according to claim 1 or claim 2 wherein the content of the polymerizable acrylic monomer (a) in the composition is 15 to 35 wt.%.

4. A method according to any preceding claim wherein the content of the epoxy resin composition (d) in the composition is 30 to 60 wt.%.
